# EUROPEAN PATENT APPLICATION

(11) **EP 4 593 049 A1**
(43) Date of publication of application: **30.07.2025**
(21) Application number: 24219769.7
(22) Date of filing: 13.12.2024
(51) Int. Cl.: H01G 4/232, H01G 4/30, H01G 4/12

(54) **MULTILAYER ELECTRONIC COMPONENT AND METHOD OF MANUFACTURING THE SAME**

(30) Priority: 23.01.2024 KR 20240009846
(71) Applicant: Samsung Electro-Mechanics Co., Ltd., Gyeonggi-do (KR)
(72) Inventor: Bak, Chae Won, Suwon-si, Gyeonggi-do (KR); Choi, Hyung Jong, Suwon-si, Gyeonggi-do (KR); Lee, Chung Eun, Suwon-si, Gyeonggi-do (KR); Kim, Yong Min, Suwon-si, Gyeonggi-do (KR); Lee, Sang Hyeon, Suwon-si, Gyeonggi-do (KR); Heo, Jae Eun, Suwon-si, Gyeonggi-do (KR)
(74) Representative: Grünecker Patent- und Rechtsanwälte PartG mbB

(57) **Abstract**

A multilayer electronic component includes a body including a dielectric layer and first and second internal electrodes alternately disposed with the dielectric layer therebetween, and including first and second surfaces opposing each other in a first direction, third and fourth surfaces opposing each other in a second direction, and fifth and sixth surfaces opposing each other in a third direction; and an external electrode including a connection portion disposed on the third or fourth surface and a band portion extending from the connection portion to portions of the first and second surfaces, wherein the external electrode includes a sputtered layer disposed in the connection portion and contacting the first or second internal electrode and including Cu, an oxide layer disposed on the sputtered layer and including a Cu oxide, and a conductive polymer layer disposed in the band portion and including a polymer material.

## Description

### CROSS-REFERENCE TO RELATED APPLICATION(S)

This application claims benefit of priority to Korean Patent Application No. 10-2024-0009846 filed on January 23, 2024 in the Korean Intellectual Property Office, the disclosure of which is incorporated herein by reference in its entirety.

### TECHNICAL FIELD

The present disclosure relates to a multilayer electronic component and a method for manufacturing the same.

A multilayer ceramic capacitor (MLCC), a multilayer electronic component, may be a chip condenser mounted on the printed circuit boards of various types of electronic products, such as image display devices including a liquid crystal display (LCD), a plasma display panel (PDP), or the like, a computer, a smartphone, a mobile phone, or the like, and serving to charge or discharge electricity therein or therefrom. The MLCC may be used as a component of various electronic devices due to advantages thereof of having a decreased size, ensuring high capacitance, and being easy to mount.

An external electrode of the MLCC may be generally formed of a Cu sintered electrode and a plated layer formed on the sintered electrode. Meanwhile, when mounting the MLCC on a printed circuit board, an impact may be applied to the MLCC, and cracks caused by such an impact may reduce reliability of the MLCC.

To solve these problems, in the MLCC for electric/electronic/industrial use, there may be cases in which an external electrode containing a conductive resin layer including a metal particle, and a resin such as an epoxy resin or the like, formed on a Cu sintered electrode, is used.

However, in the MLCC for small IT products, when the conductive resin layer is applied, a thickness of the external electrode may increase, which may reduce capacitance per unit volume of the MLCC. Therefore, research into a structure of an external electrode suppressing cracks from occurring during mounting while not reducing the capacitance per unit volume of the MLCC is required.

### SUMMARY

An aspect of the present disclosure is to provide a multilayer electronic component having excellent reliability.

The purposes of the present disclosure are not limited to the above-described contents, and can be more easily understood in a process of explaining specific embodiments of the present disclosure.

According to an aspect of the present disclosure, a multilayer electronic component includes a body including a dielectric layer and first and second internal electrodes alternately disposed with the dielectric layer therebetween, and including a first surface and a second surface opposing each other in a first direction, a third surface and a fourth surface, connected to the first and second surfaces and opposing each other in a second direction, and a fifth surface and a sixth surface, connected to the first to fourth surfaces and opposing each other in a third direction; and an external electrode including a connection portion disposed on the third surface and/or the fourth surface, and a band portion extending from the connection portion to a portion of the first surface and a portion of the second surface, wherein the external electrode includes a sputtered layer disposed in the connection portion and contacting the first and/or second internal electrode and including Cu, an oxide layer disposed on the sputtered layer and including a Cu oxide, and a conductive polymer layer disposed in the band portion and including a polymer material.

According to another aspect of the present disclosure, a multilayer electronic component includes a body including a dielectric layer and first and second internal electrodes alternately disposed with the dielectric layer therebetween, and including a first surface and a second surface opposing each other in a first direction, a third surface and a fourth surface, connected to the first and second surfaces and opposing each other in a second direction, and a fifth surface and a sixth surface, connected to the first to fourth surfaces and opposing each other in a third direction; and an external electrode including a connection portion disposed on the third surface and/or the fourth surface, and a band portion extending from the connection portion to a portion of the first surface and a portion of the second surface, wherein the external electrode includes a first layer disposed in the connection portion and directly contacting the first and/or second internal electrode and including Cu, where an amount (at%) of Cu among a total amount (at%) of elements constituting the first layer is 99 at% or more, an oxide layer disposed on the first layer and including a Cu oxide, and a conductive polymer layer disposed in the band portion and including a polymer material.

According to yet another aspect of the present disclosure, a method of manufacturing a multilayer electronic component includes preparing a body including a dielectric layer and first and second internal electrodes alternately disposed with the dielectric layer therebetween, and including a first surface and a second surface opposing each other in a first direction, a third surface and a fourth surface, connected to the first and second surfaces and opposing each other in a second direction, and a fifth surface and a sixth surface, connected to the first to fourth surfaces and opposing each other in a third direction; performing an electrode formation operation including a first operation including forming a Cu film on the third surface and the fourth surface by a sputtering method, and a second operation including applying a polymer composition to at least one surface among the first surface and the second surface, wherein the first operation and the second operation are performed sequentially or in reverse order; and performing a heat-treatment operation including heat-treating the body on which the electrode formation operation has been performed to oxidize an external surface of the Cu film.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a perspective view schematically illustrating a multilayer electronic component according to an embodiment of the present disclosure.
FIG. 2 schematically illustrates a cross-sectional view of FIG. 1, taken along line I-I'.
FIG. 3 schematically illustrates a cross-sectional view of FIG. 1, taken along line II-II'.
FIG. 4 schematically illustrates a cross-sectional view of FIG. 1, taken along line III-III'.
FIG. 5 schematically illustrates a cross-sectional view of FIG. 2, taken along line IV-IV'.
FIG. 6 schematically illustrates a cross-sectional view of FIG. 2, taken along line V-V'.
FIG. 7 is a modified example of FIG. 3.
FIG. 8 is a modified example of FIG. 5.
FIG. 9 is a modified example of FIG. 6.
FIGS. 10 to 13 are cross-sectional views schematically illustrating a multilayer electronic component according to other embodiments of the present disclosure, and are views corresponding to FIG. 2.
FIGS. 14 and 15 are views schematically illustrating a method for manufacturing a multilayer electronic component according to an embodiment of the present disclosure.

### DETAILED DESCRIPTION

Hereinafter, embodiments of the present disclosure will be described with reference to specific embodiments and the accompanying drawings. However, embodiments of the present disclosure may be modified into various other forms, and the scope of the present disclosure is not limited to the embodiments described below. Further, embodiments of the present disclosure may be provided for a more complete description of the present disclosure to the ordinarily skilled artisan. Therefore, shapes, sizes, and the like, of the elements in the drawings may be exaggerated for clarity of description, and the elements denoted by the same reference numerals in the drawings may be the same elements.

In addition, in order to clearly explain the present disclosure in the drawings, portions not related to the description will be omitted for clarification of the present disclosure, and a thickness may be enlarged to clearly illustrate layers and regions. The same reference numerals will be used to designate the same components in the same reference numerals. Further, throughout the specification, when an element is referred to as "comprising" or "including" an element, it means that the element may further include other elements as well, without departing from the other elements, unless specifically stated otherwise.

In the drawings, a first direction may be defined as a thickness (T) direction, a second direction may be defined as a length (L) direction, and a third direction may be defined as a width (W) direction.

### Multilayer Electronic Component

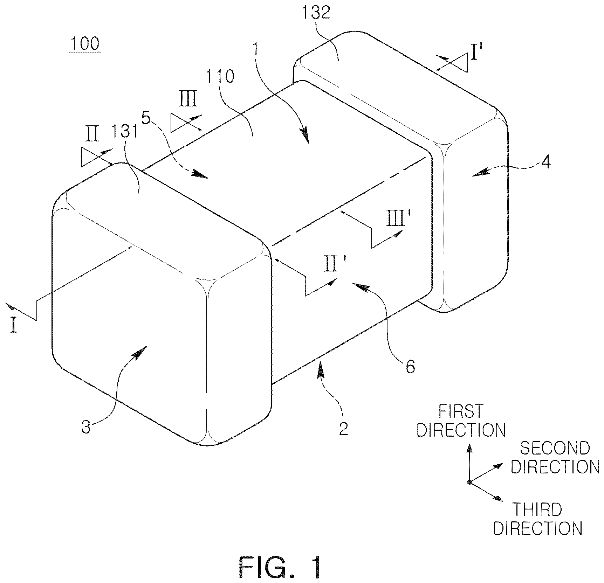

FIG. 1 is a perspective view schematically illustrating a multilayer electronic component according to an embodiment of the present disclosure.

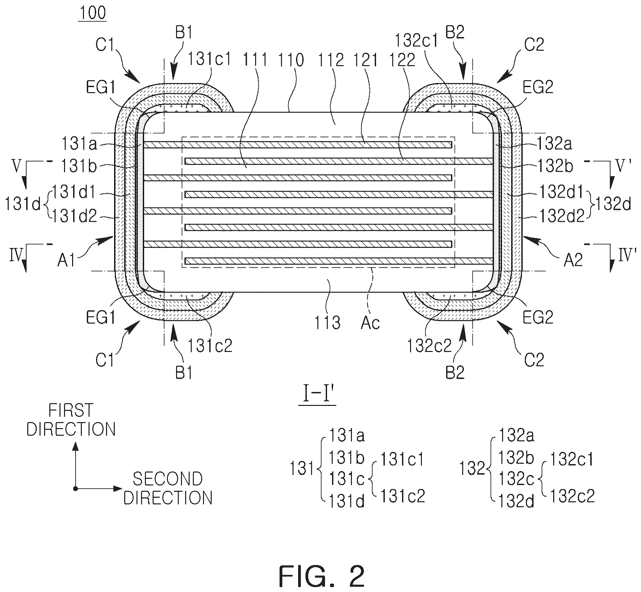

FIG. 2 schematically illustrates a cross-sectional view of FIG. 1, taken along line I-I'.

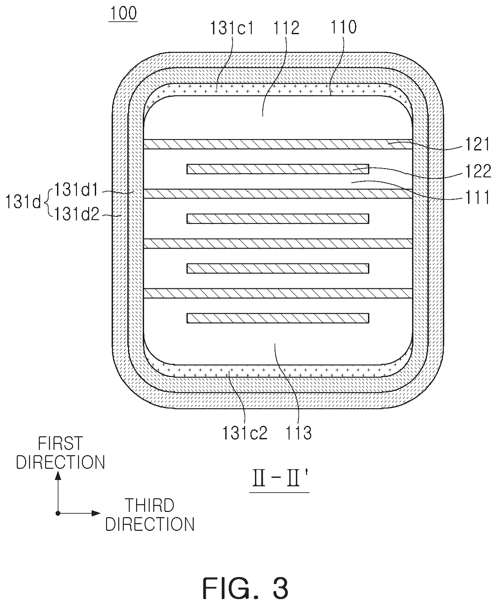

FIG. 3 schematically illustrates a cross-sectional view of FIG. 1, taken along line II-II'.

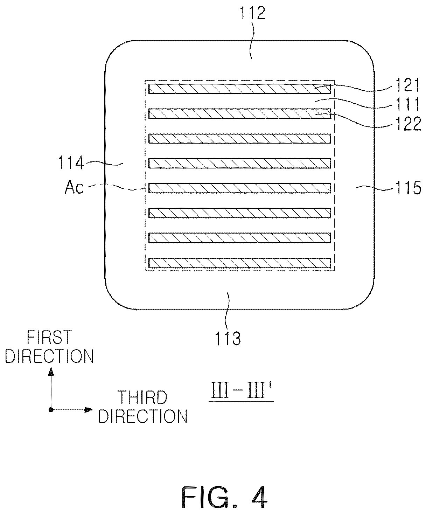

FIG. 4 schematically illustrates a cross-sectional view of FIG. 1, taken along line III-III'.

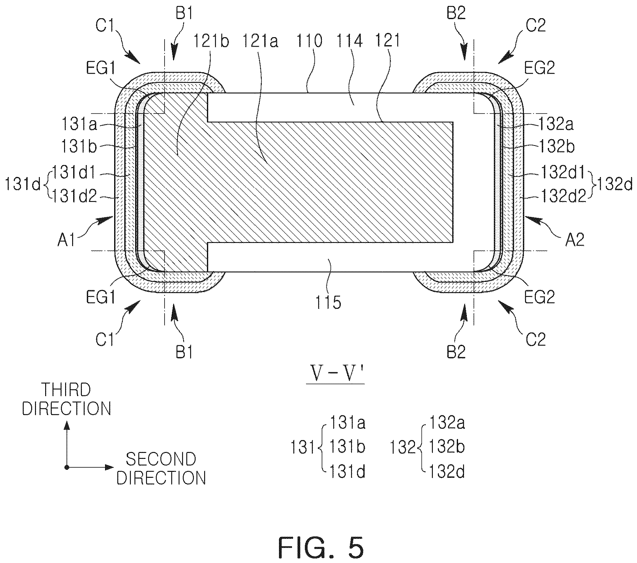

FIG. 5 schematically illustrates a cross-sectional view of FIG. 2, taken along line IV-IV'.

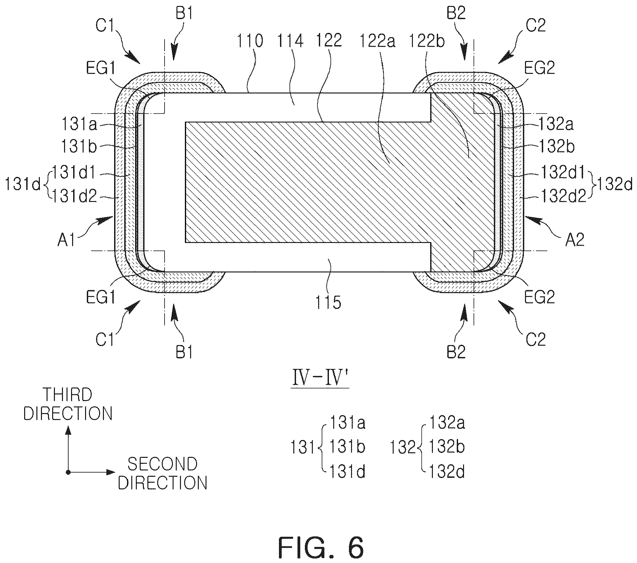

FIG. 6 schematically illustrates a cross-sectional view of FIG. 2, taken along line V-V'.

Hereinafter, a multilayer electronic component 100 according to an embodiment of the present disclosure will be described in detail with reference to FIGS. 1 to 6. In addition, a multilayer ceramic capacitor will be described as an example of the multilayer electronic component, but the present disclosure is not limited thereto, and may be applied to various multilayer electronic components, such as an inductor, a piezoelectric element, a varistor, a thermistor, or the like.

A size of the multilayer electronic component 100 is not particularly limited. A maximum dimension of the multilayer electronic component 100 in the second direction may be, for example, 0.2 mm to 5.0 mm, a maximum dimension of the multilayer electronic component 100 in the third direction may be, for example, 0.2 mm to 5.0 mm, and a maximum dimension of the multilayer electronic component 100 in the first direction may be, for example, 0.04 mm to 0.3 mm.

The multilayer electronic component 100 may include a body 110 and an external electrode 131 and 132. There may be no particular limitation on a specific shape of the body 110, but as illustrated, the body 110 may be formed in a hexahedral shape or a similar shape. The body 110 may not have an entirely straight hexahedral shape, but may have a substantially hexahedral shape.

The body 110 may have first and second surfaces 1 and 2 opposing each other in the first direction, third and fourth surfaces 3 and 4 connected to the first and second surfaces 1 and 2 and opposing each other in the second direction, and fifth and sixth surfaces 5 and 6 connected to the first to fourth surfaces 1, 2, 3, and 4 and opposing each other in the third direction.

The body 110 may include a first edge EG1 connecting the third surface 3 and the first, second, fifth, and sixth surfaces 1, 2, 5, and 6, and a second edge EG2 connecting the fourth surface 4 and the first, second, fifth, and sixth surfaces 1, 2, 5, and 6. The first and second edges EG1 and EG2 may have a round shape by performing a separate polishing process. The first to sixth surfaces 1, 2, 3, 4, 5, and 6 may be generally flat surfaces, and unflat regions may be regarded as the edges.

The body 110 may include a dielectric layer 111 and internal electrodes 121 and 122 alternately disposed with the dielectric layer 111. A plurality of dielectric layers 111 forming the body 110 may be in a sintered state, and a boundary between adjacent dielectric layers 111 may be integrated to such an extent that it may be difficult to identify the same without using a scanning electron microscope (SEM).

The dielectric layer 111 may include, for example, a perovskite-type compound represented by ABO₃ as a main component. The perovskite-type compound represented by ABO₃ may be, for example, BaTiO₃, (Ba₁₋ₓCaₓ)TiO₃(0<x<1), Ba(Ti_{1-y}Ca_{y})O₃(0<y<1), (Ba₁₋ₓCaₓ)(Ti_{1-y}Zr_{y})O₃(0<x<1, 0<y<1), Ba(Ti_{1-y}Zr_{y})O₃(0<y<1), CaZrO₃, or (Ca₁₋ₓSrₓ)(Zr_{1-y}Ti_{y})O₃(0<x<0.5, 0<y≤0.5).

An average thickness of the dielectric layer 111 is not particularly limited. The average thickness of the dielectric layer 111 may be, for example, 0.1 um to 10 um, 0.1 um to 5 um, 0.1 um to 2 um, or 0.1 um to 0.4 µm.

The internal electrodes 121 and 122 may include a first internal electrode 121 and a second internal electrode 122, alternately disposed with the dielectric layer 111 therebetween. For example, the first internal electrode 121 and the second internal electrode 122, which may be a pair of electrodes having different polarities, may be disposed to oppose each other with the dielectric layer 111 therebetween. The first internal electrode 121 and the second internal electrode 122 may be electrically separated from each other by the dielectric layer 111 disposed therebetween.

The first internal electrode 121 may be spaced apart from the fourth surface 4 and exposed from the third surface 3 to be connected to a first external electrode 131. The second internal electrode 122 may be spaced apart from the third surface 3 and exposed from the fourth surface 4 to be connected to a second external electrode 132.

A conductive metal included in the internal electrode 121 and 122 may be at least one of Ni, Cu, Pd, Ag, Au, Pt, Sn, W, Ti, or alloys thereof, and more preferably may include Ni, but the present disclosure is not limited thereto.

An average thickness of the internal electrode 121 and 122 may not be particularly limited. The average thickness of the internal electrode 121 and 122 may be, for example, 0.1 um to 3.0 um, 0.1 um to 1.0 um, or 0.1 um to 0.4 µm.

The average thickness of the dielectric layer 111 and the average thickness of the internal electrode 121 and 122 mean an average dimension of the dielectric layer 111 and an average dimension of the internal electrode 121 and 122 in the first direction, respectively. The average thickness of the dielectric layer 111 and the average thickness of the internal electrode 121 and 122 may be measured by scanning cross-sections of the body 110 in the first and second directions with a scanning electron microscope (SEM) at 10,000 magnification. More specifically, the average thickness of the dielectric layer 111 may be determined by measuring thicknesses at multiple points of one dielectric layer 111, for example, at thirty equally spaced points in the second direction, and then taking an average value. In addition, the average thickness of the internal electrode 121 and 122 may be determined by measuring thicknesses at multiple points of one internal electrode 121 and 122, for example, at thirty equally spaced points in the second direction, and then taking an average value. The thirty equally spaced points may be designated in a capacitance formation portion Ac. When the value of the average thickness is determined by using measurements of average values to ten dielectric layers 111 and ten internal electrodes 121 and 122, and measuring the average value, the average thickness of the dielectric layer 111 and the average thickness of the internal electrode 121 and 122 may be more generalized.

The body 110 may include a capacitance formation portion Ac disposed in the body 110 and including the dielectric layer 111 and the first and second internal electrodes 121 and 122 alternately disposed, to form capacitance, and a cover portion 112 and 113 disposed on opposite surfaces of the capacitance forming portion Ac in the first direction. The cover portion 112 and 113 may have the same configuration as the dielectric layer 111 except that they do not include internal electrodes.

An average thickness of the cover portion 112 and 113 is not particularly limited. The average thickness of the cover portion 112 and 113 may be, for example, 100 um or less, 30 um or less, or 20 um or less. The average thickness of the cover portion 112 and 113 may be, for example, 5 um or more. In this case, the average thickness of the cover portion 112 and 113 means an average thickness of each of a first cover portion 112 and a second cover portion 113.

The average thickness of the cover portion 112 and 113 may mean an average dimension of the cover portion 112 and 113 in the first direction, and may be an average value of dimensions in the first direction, measured at five equally spaced points in the second direction, in a plane of the body 110 in the first and second directions, cut from a center of the third direction.

The body 110 may include margin portions 114 and 115 respectively disposed on both surfaces of the capacitance formation portion Ac in the third direction. For example, the margin portions 114 and 115 may mean regions between both ends of the internal electrode 121 and 122 and a boundary surface of the body 110 in a cross-section of the body 110 in the first and third directions cut from a center of the second direction. The margin portions 114 and 115 may have a configuration similar to that of the dielectric layer 111 except that they do not include the internal electrode 121 and 122.

An average thickness of the margin portion 114 and 115 is not particularly limited. The average thickness of the margin portion 114 and 115 may be, for example, 100 um or less, 20 um or less, or 15 um or less. The average thickness of the margin portion 114 and 115 may be, for example, 2 um or more. In this case, the average thickness of the margin portion 114 and 115 means an average thickness of each of a first margin portion 114 and a second margin portion 115. The average thickness of the margin portion 114 and 115 may mean an average dimension of the margin portion 114 and 115 in the third direction, and may be an average value of dimensions in the third direction, measured at five equally spaced points in the first direction, in a plane of the body 110 in the first and third directions, cut from a center of the second direction.

The external electrode 131 and 132 may include a connection portion A1 and A2 disposed on the third surface 3 or the fourth surface 4 and a band portion B1 and B2 extending from the connection portion A1 and A2 to a portion of the first surface and the second surface 1 and 2. In addition, the external electrode 131 and 132 may include a corner portion C1 and C2 disposed between the connection portion A1 and A2 and the band portion B1 and B2. The external electrode 131 and 132 may include a first external electrode 131 connected to the first internal electrode 121, and a second external electrode 132 connected to the second internal electrode 122.

The first external electrode 131 may include a first connection portion A1 disposed on the third surface 3, a first band portion B1 extending from the first connection portion A1 to a portion of the first surface 1 and a portion of the second surface 2, and a first corner portion C1 disposed between the first connection portion A1 and the first band portion B1. The second external electrode 132 may include a second connection portion A2 disposed on the fourth surface 4, a second band portion B2 extending from the second connection portion A2 to a portion of the first surface 1 and a portion of the second surface 2, and a second corner portion C2 disposed between the second connection portion A2 and the second band portion B2.

A boundary between the first connection portion A1 and the first corner portion C1 may be defined as a point at which the third surface 3 and the first edge EG1 meet, and a boundary between the second connection portion A2 and the second corner portion C2 may be defined as a point at which the fourth surface 4 and the second edge EG2 meet. A boundary between the first band portion B1 and the first corner portion C1 may be defined as a point at which the first surface, the second surface, the fifth surface, and the sixth surface 1, 2, 5, and 6 meet the first edge EG1, and a boundary between the second band portion B2 and the second corner portion C2 may be defined as a point at which the first surface, the second surface, the fifth surface, and the sixth surface 1, 2, 5, and 6 meet the second edge EG2.

The external electrode 131 and 132 may include a sputtered layer 131a and 132a disposed in the connection portion A1 and A2 and contacting the internal electrode 121 and 122. For example, the first external electrode 131 may include a first sputtered layer 131a disposed in the first connection portion A1 and contacting the first internal electrode 121, and the second external electrode 132 may include a second sputtered layer 132a disposed in the second connection portion A2 and contacting the second internal electrode 122.

The sputtered layer 131a and 132a may serve to electrically connect the internal electrode 121 and 122 and the external electrode 131 and 132. Since the sputtered layer 131a and 132a is basically formed through a sputtering method, they may be thin and uniform in thickness. Therefore, by thinning the external electrode 131 and 132, capacitance per unit volume of the multilayer electronic component 100 may be improved. In addition, since the external electrode 131 and 132 may secure a thickness of a certain level or more even in the corner portion C1 and C2 due to the sputtered layer 131a and 132a, penetration of external moisture, plating solution, or the like may be effectively blocked. The thickness of the sputtered layer 131a and 132a is not particularly limited, and may have a thickness of several tens of nm to several tens of µm.

Since the sputtered layer 131a and 132a may be formed through a sputtering method, they may be directly formed on an external surface of the body 110 without a separate additional process for the body 110. For example, when a plated layer is directly formed on the body 110 through an electrolytic plating method, a problem may occur in which the plated layer may not be formed on a side surface of the cover portion, which may be mainly formed of ceramic components. In the sputtering method, unlike the electrolytic plating method, since a separate metal seed is not required, the sputtered layer 131a and 132a may be uniformly formed on the side surface of the cover portion 112 and 113 and the edge EG1 and EG2 of the body 110. As a result, one end of the sputtered layer 131a and 132a may be disposed in the corner portion C1 and C2. In addition, the sputtered layer 131a and 132a may come into contact with at least a portion of the edge EG1 and EG2 of the body 110.

In addition, when directly forming the plated layer on the body 110 through an electrolytic plating method, a process of immersing the body 110 in an acidic solution may be required, and there may be a concern that insulation resistance of the dielectric layer 111 may deteriorate due to penetration of the acidic solution or generation of hydrogen during this process. In a multilayer electronic component 100 according to an embodiment of the present disclosure, since the sputtered layer 131a and 132a may be formed by a sputtering method, penetration of the acidic solution or generation of hydrogen may be prevented.

The sputtered layer 131a and 132a may include Cu. Since the sputtered layer 131a and 132a includes Cu, an oxide layer 131b and 132b including a Cu oxide may be formed by a heat-treatment process to be described below. Since the sputtered layer 131a and 132a is formed by a sputtering method, an amount (at%) of Cu among a total amount (at%) of elements constituting the sputtered layer 131a and 132a may be 99 at% or more. The sputtered layer 131a and 132a may further include Ni, but the present disclosure is not limited thereto. An amount of Cu may be calculated from an image scanned using SEM-EDS. Specifically, after the multilayer electronic component 100 may be polished to a position of a central portion in the third direction, to expose a cross-section in the first and second directions, the amount (at%) of Cu among the total amount of elements constituting the sputtered layer 131a and 132a may be measured using SEM-EDS. Other methods and/or tools appreciated by one of ordinary skill in the art, even if not described in the present disclosure, may also be used.

Since the sputtered layer 131a and 132a is formed by a sputtering method, it may not contain a glass component, unlike a sintered electrode used in the prior art. This makes it possible to improve ESR characteristics of the multilayer electronic component 100, as compared to the prior art.

The external electrode 131 and 132 may include the oxide layer 131b and 132b disposed on the sputtered layer 131a and 132a. For example, the first external electrode 131 may include a first oxide layer 131b disposed on the first sputtered layer 131a, and the second external electrode 132 may include a second oxide layer 132b disposed on the second sputtered layer 132a.

The oxide layer 131b and 132b may include a Cu oxide. A type of the Cu oxide included in the oxide layer 131b and 132b is not particularly limited, but may include, for example, one or more of Cu₂O and CuO. Since the Cu oxide has low moisture permeability and hydrogen diffusion coefficient, the oxide layer 131b and 132b may play a role in preventing external moisture or hydrogen from penetrating into the body 110.

The drawings illustrate that the oxide layer 131b and 132b is formed continuously between the sputtered layer 131a and 132a and a plated layer 131d and 132d, but the present disclosure is not limited thereto, and the oxide layer 131b and 132b may be formed discontinuously depending on conditions of a heat-treatment operation described later. The oxide layer 131b and 132b may be disposed on an interface between the sputtered layer 131a and 132a and the plated layer 131d and 132d, but may not be disposed on an interface between the sputtered layer 131a and 132a and a conductive polymer layer 131c and 132c. Alternatively, a ratio of a sum of lengths of regions in which the oxide layer is formed relative to an entire length of the interface between the sputtered layer 131a and 132a and the plated layer 131d and 132d may be higher than a ratio of a sum of lengths of regions in which the oxide layer is formed relative to an entire length of the interface between the sputtered layer 131a and 132a and the conductive polymer layer 131c and 132c.

The external electrode 131 and 132 may include the conductive polymer layer 131c and 132c disposed in the band portion B1 and B2. For example, the first external electrode 131 may include a first conductive polymer layer 131c disposed in the first band portion B1, and the second external electrode 132 may include a second conductive polymer layer 132c disposed in the second band portion B2.

The conductive polymer layer 131c and 132c basically include a polymer material, and thus may play a role in preventing cracks from occurring in the multilayer electronic component 100 due to impacts generated when the multilayer electronic component 100 is mounted on a printed circuit board. For example, the conductive polymer layer 131c and 132c may reduce stress applied to the multilayer electronic component 100, to improve impact resistance of the multilayer electronic component 100.

A type of the polymer material is not particularly limited. The polymer material may be an insulating material. For example, the polymer material may include an insulating resin. The insulating resin may be, for example, one or more of an epoxy resin, an acrylic resin, and ethyl cellulose. In this case, the conductive polymer layer 131c and 132c may further include metal particles.

The metal particles may include one or more of spherical particles and flake-shaped particles. In this case, the spherical particles may also include shapes other than perfectly spherical, for example, shapes having a length ratio of a major axis to a minor axis (major axis/minor axis) of 1.45 or less. The flake-shaped particles refer to particles having a flat and elongated shape, and are not particularly limited, for example, may have a length ratio of the major axis to the minor axis (major axis/minor axis) of 1.95 or more. The metal particles may include, for example, Cu, Ni, Pd, Pt, Au, Ag, Pb, Sn, and/or alloys including them.

In addition, the polymer material may be a conductive material. For example, the polymer material may include one or more of polypyrrole, polyaniline, polythiophene, and PEDOT:PSS. In this case, the conductive polymer layer (131c and 132c) may be formed of one or more conductive polymers of polypyrrole, polyaniline, polythiophene, and PEDOT:PSS, and may not include metal particles.

A shape of the conductive polymer layer 131c and 132c is not particularly limited. In an embodiment, the conductive polymer layer 131c and 132c may include a first layer 131c1 and 132c1 disposed on the first surface 1, and a second layer 131c2 and 132c2 spaced apart from the first layer 131c1 and 132c1 and disposed on the second surface 2. The conductive polymer layer 131c and 132c may be disposed, for example, on the first and second surfaces 1 and 2, but not on the fifth and sixth surfaces 5 and 6. However, the present disclosure is not limited thereto, and the conductive polymer layer 131c and 132c may be disposed on a portion of the first, second, fifth, and sixth surfaces 1, 2, 5, and 6.

Since the conductive polymer layer 131c and 132c have higher resistance than the sputtered layer 131a and 132a, when the conductive polymer layer 131c and 132c comes into direct contact with the internal electrode 121 and 122, ESR characteristics of the multilayer electronic component 100 may deteriorate. In an embodiment, the conductive polymer layer 131c and 132c may not be disposed in the connection portion A1 and A2. For example, the first conductive polymer layer 131c may not be disposed in the first connection portion A1, and the second conductive polymer layer 132c may not be disposed in the second connection portion A2.

In addition, a structure of the sputtered layer 131a and 132a and a structure of the conductive polymer layer 131c and 132c in the corner portion C1 and C2 may be changed, depending on an order of first and second processes to be described below. For example, as illustrated in FIG. 2, the conductive polymer layer 131c and 132c in the corner portion C1 and C2 may cover one end of the sputtered layer 131a and 132a. For example, the first conductive polymer layer 131c in the first corner portion C1 may cover one end of the first sputtered layer 131a, and the second conductive polymer layer 132c in the second corner portion C2 may cover one end of the second sputtered layer 132a.

A thickness of the conductive polymer layer 131c and 132c is not particularly limited, but may be 0.5 um or more and 3.0 um or less. When the thickness of the conductive polymer layer 131c and 132c is less than 0.5 um, an effect of improving impact resistance of the present disclosure may be minimal. In addition, when the thickness of the conductive polymer layer 131c and 132c exceeds 3.0 um, capacitance per unit volume of the multilayer electronic component may be reduced. In this case, the thickness of the conductive polymer layer 131c and 132c may mean a dimension in the first direction, measured from a central portion of the conductive polymer layer 131c and 132c in the second direction, in a cross-section of the body 110 in the first and second directions, cut from a center of the third direction.

The external electrode 131 and 132 may include the plated layer 131d and 132d disposed on the oxide layer 131b and 132b and the conductive polymer layer 131c and 132c. The plated layer 131d and 132d may improve mounting characteristics.

The plated layer 131d and 132d may include, for example, Ni, Sn, Pd, and/or an alloy including them, and may be formed as a plurality of layers. The plated layer 131d and 132d may be, for example, a Ni plated layer or a Sn plated layer, and may be formed in a form in which the Ni plated layer and the Sn plated layer are sequentially formed. In addition, the plated layer 131d and 132d may include a plurality of Ni plated layers and/or a plurality of Sn plated layers.

In an embodiment, the external electrode 131 and 132 may include a Ni plated layer 131d1 and 132d1 disposed on the oxide layer 131b and 132b in the connection portion A1 and A2, and a Sn plated layer 131d2 and 132d2 disposed on the conductive polymer layer 131c and 132c in the band portion B1 and B2.

A thickness of the plated layer 131d and 132d is not particularly limited. For example, a thickness of the Ni plated layer 131d1 and 132d1 may be 2 um or more and 4 um or less, and a thickness of the Sn plated layer 131d2 and 132d2 may be 2 um or more and 4 um or less. In an embodiment, a thickness of the conductive polymer layer 131c and 132c measured in the band portion B1 and B2 may be smaller than a thickness of the Ni plated layer 131d1 and 132d1 measured in the band portion B1 and B2.

The drawings illustrate a structure in which the multilayer electronic component 100 has two external electrodes 131 and 132, but is not limited thereto, and the number, shapes, or the like of the external electrodes 131 and 132 may be changed, depending on a shape of the internal electrode (121 and 122) or other purposes.

The internal electrode 121 and 122 may include a main portion 121a and 122a and a lead portion 121b and 122b extending from the main portion 121a and 122a to the third surface 3 and/or the fourth surface 4 and making contact with the external electrode (131 and 132). For example, the first internal electrode 121 may include a first main portion 121a, and a first lead portion 121b extending from the first main portion 121a to the third surface 3 and contacting the first external electrode 131, and the second internal electrode 122 may include a second main portion 122a, and a second lead portion 122b extending from the second main portion 122a to the fourth surface 4 and contacting the second external electrode 132.

In an embodiment, a dimension of the lead portion 121b and 122b in the third direction may be larger than a dimension of the main portion 121a and 122a in the third direction. More specifically, the lead portion 121b and 122b may be exposed to the fifth surface and the sixth surface 5 and 6 of the body 110. For example, the first lead portion 121b may be in contact with the first external electrode 131 on the third, fifth, and sixth surfaces 3, 5, and 6, and the second lead portion 122b may be in contact with the second external electrode 132 on the fourth, fifth, and sixth surfaces 4, 5, and 6. The lead portion 121b and 122b exposed from the fifth and sixth surfaces 5 and 6 may serve as metal seeds for forming the plated layer 131d and 132d on the fifth and sixth surfaces 5 and 6.

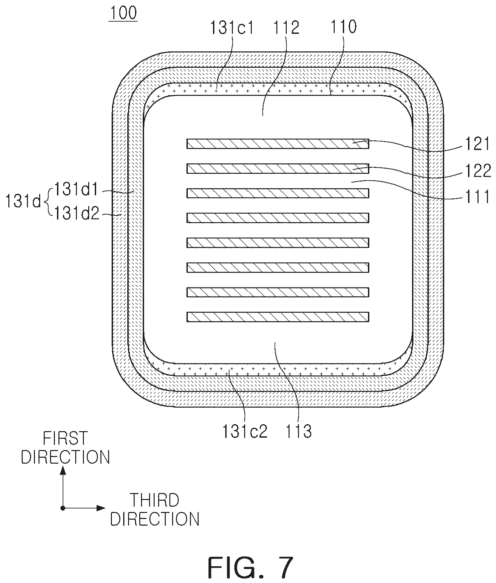

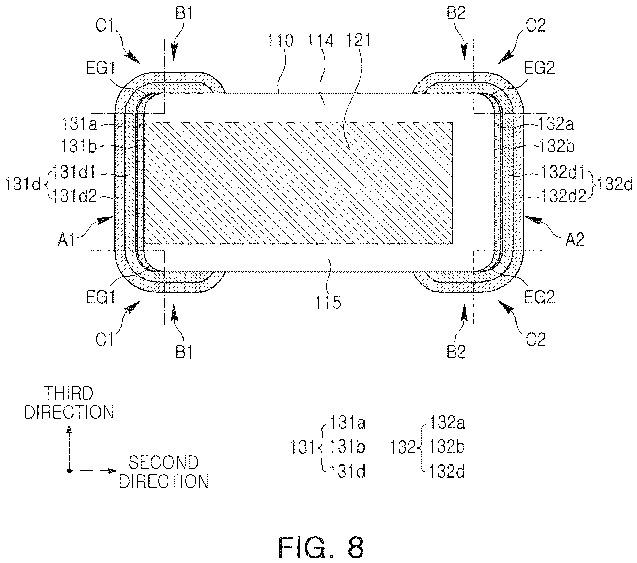

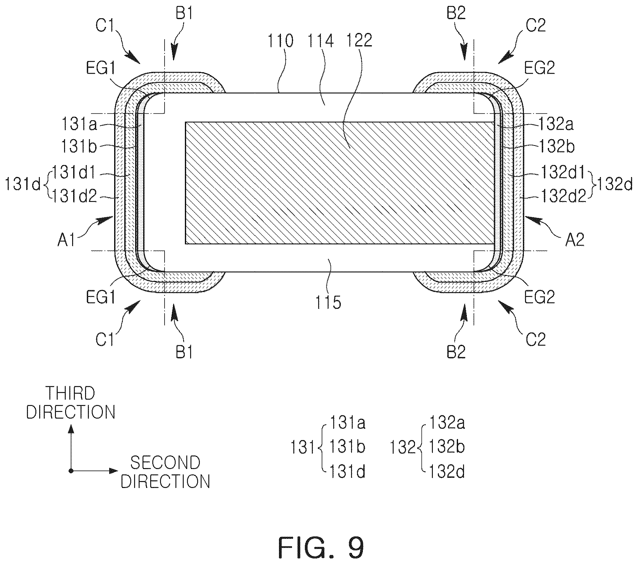

However, the present disclosure is not limited thereto, and the internal electrode 121 and 122 may be disposed to be spaced apart from the fifth and sixth surfaces 5 and 6 of the body 110. FIG. 7 is a modified example of FIG. 3. FIG. 8 is a modified example of FIG. 5. FIG. 9 is a modified example of FIG. 6. Referring to FIGS. 7 to 9, a first internal electrode 121 may be disposed to contact a first external electrode 131 on a third surface 3 but to be spaced apart from fifth and sixth surfaces 5 and 6, and a second internal electrode 122 may be disposed to contact a second external electrode 132 on a fourth surface 4 but to be spaced apart from the fifth and sixth surfaces 5 and 6. In this case, unevenness may be formed on some or all of the fifth and sixth surfaces 5 and 6, but is not limited thereto.

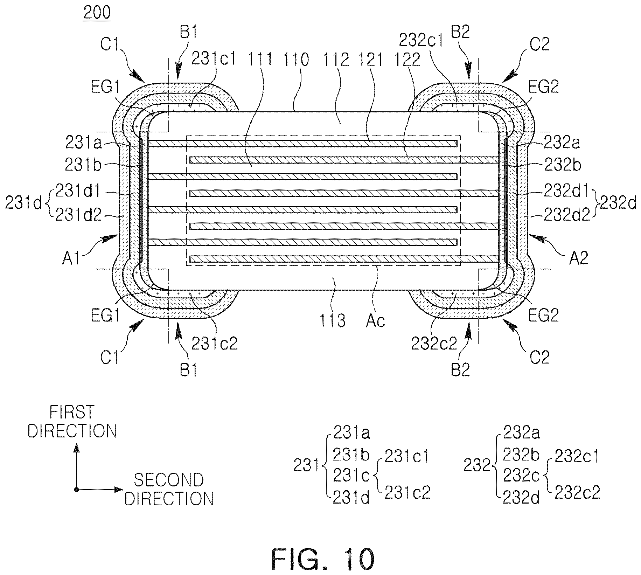

FIGS. 10 to 13 are cross-sectional views schematically illustrating a multilayer electronic component according to another embodiment of the present disclosure, and are views corresponding to FIG. 2. Hereinafter, a multilayer electronic component according to another embodiment of the present disclosure will be described with reference to FIGS. 10 to 13. The same/similar reference numerals may be used for configurations identical/similar to those of the multilayer electronic component 100 described in FIGS. 1 to 6, and duplicate descriptions may be omitted.

Referring to FIG. 10, a multilayer electronic component 200 according to an embodiment of the present disclosure may include a body 110 and an external electrode 231 and 232.

The external electrode 231 and 232 may include a sputtered layer 231a and 232a disposed in a connection portion A1 and A2, contacting an internal electrode 121 and 122, and including Cu, an oxide layer 231b and 232b disposed on the sputtered layer 231a and 232a and including a Cu oxide, a conductive polymer layer 231c and 232c disposed in a band portion B1 and B2 and including a polymer material, and a plated layer 231d and 232d disposed on the oxide layer 231b and 232b and the conductive polymer layer 231c and 232c.

The conductive polymer layer 231c and 232c may include, for example, a first layer 231c1 and 232c1 disposed on the first surface, and a second layer 231c2 and 232c2 disposed on the second surface and spaced apart from the first layer 231c1 and 232c1.

The plated layer 231d and 232d may include a Ni plated layer 231d1 and 232d1 disposed on the oxide layer 231b and 232b in the connection portion A1 and A2 and disposed on the conductive polymer layer 231c and 232c in the band portion B1 and B2, and a Sn plated layer 231d2 and 232d2 disposed on the Ni plated layer 231d1 and 232d1.

In a multilayer electronic component 200 according to an embodiment of the present disclosure, one end of the conductive polymer layer 231c and 232c may be disposed in the connection portion A1 and A2. For example, one end of a first conductive polymer layer 231c may be disposed in a first connection portion A1, and one end of a second conductive polymer layer 232c may be disposed in a second connection portion A2. In this case, cracks in the multilayer electronic component 200 due to impacts generated when mounting the multilayer electronic component 200 on a printed circuit board may be more effectively prevented.

To prevent the occurrence of a side effect of deteriorating other electrical characteristics of the multilayer electronic component 200, the conductive polymer layer 231c and 232c may be disposed not to overlap the internal electrode 121 and 122 in the second direction. The oxide layer 231b and 232b may be disposed in the connection portion A1 and A2, but may not be disposed in the band portion B1 and B2 and the corner portion C1 and C2, but the present disclosure is not limited thereto.

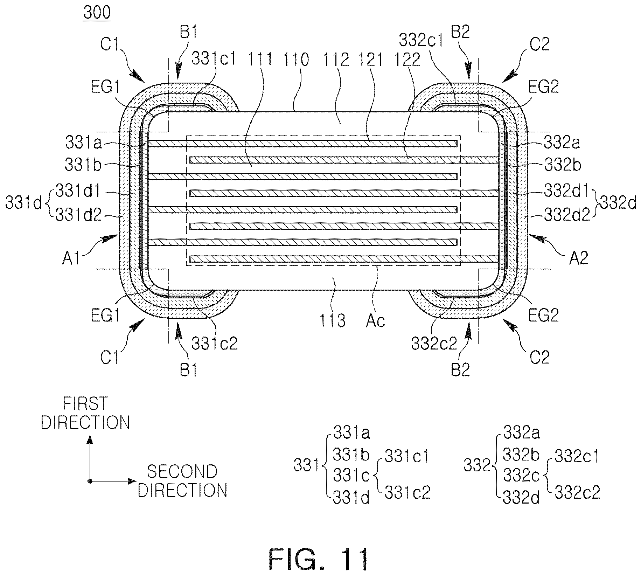

Referring to FIG. 11, a multilayer electronic component 300 according to an embodiment of the present disclosure may include a body 110 and an external electrode 331 and 332.

The external electrode 331 and 332 may include a sputtered layer 331a and 332a disposed in a connection portion A1 and A2, contacting an internal electrode 121 and 122, and including Cu, an oxide layer 331b and 332b disposed on the sputtered layer 331a and 332a and including a Cu oxide, a conductive polymer layer 331c and 332c disposed in a band portion B1 and B2 and including a polymer material, and a plated layer 331d and 332d disposed on the oxide layer 331b and 332b and the conductive polymer layer 331c and 332c.

The conductive polymer layer 331c and 332c may include, for example, a first layer 331c1 and 332c1 disposed on the first surface, and a second layer 331c2 and 332c2 disposed on the second surface and spaced apart from the first layer 331c1 and 332c1.

The plated layer 331d and 332d may include a Ni plated layer 331d1 and 332d1 disposed on the oxide layer 331b and 332b in the connection portion A1 and A2 and disposed on the conductive polymer layer 331c and 332c in the band portion B1 and B2, and a Sn plated layer 331d2 and 332d2 disposed on the Ni plated layer 331d1 and 332d1.

In a multilayer electronic component 300 according to an embodiment of the present disclosure, one end of the sputtered layer 331a and 332a may be disposed in the band portion B1 and B2. For example, one end of a first sputtered layer 331a may be disposed in a first band portion B1, and one end of a second sputtered layer 332a may be disposed in a second band portion B2. For example, the first sputtered layer 331a may be disposed on the third surface, and may extend over a portion of the first surface and a portion of the second surface, and the second sputtered layer 332a may be disposed on the fourth surface, and may extend over a portion of the first surface and a portion of the second surface.

In the band portion B1 and B2, the sputtered layer 331a and 332a may be disposed between the body 110 and the conductive polymer layer 331c and 332c. For example, in the first band portion B1, the first sputtered layer 331a may be disposed between the body 110 and a first conductive polymer layer 331c, and in the second band portion B2, the second sputtered layer 332a may be disposed between the body 110 and a second conductive polymer layer 332c. The conductive polymer layer 331c and 332c may cover an end portion of the sputtered layer 331a and 332a in the band portion B1 and B2.

The oxide layer 331b and 332b may be disposed in the connection portion A1 and A2 and a corner portion C1 and C2. The oxide layer 331b and 332b may not be disposed in the band portion B1 and B2, and thus an end portion of the oxide layer 331b and 332b may be disposed in the corner portion C1 and C2, but the present disclosure is not limited thereto.

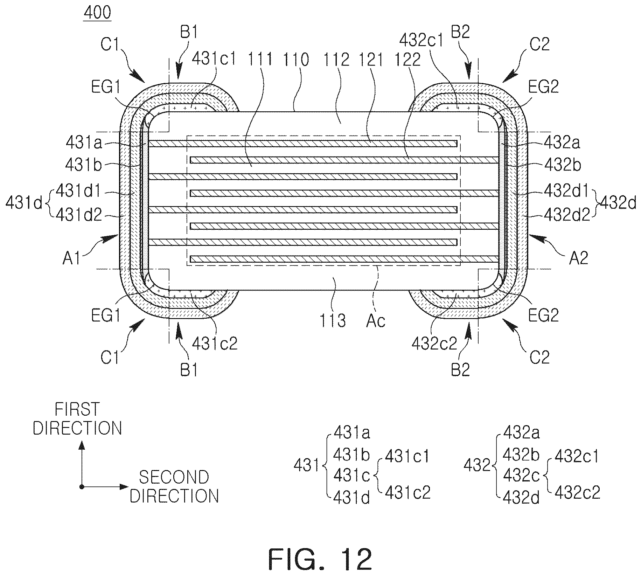

Referring to FIG. 12, a multilayer electronic component 400 according to an embodiment of the present disclosure may include a body 110 and an external electrode 431 and 432.

The external electrode 431 and 432 may include a sputtered layer 431a and 432a disposed in a connection portion A1 and A2, contacting an internal electrode 121 and 122, and including Cu, an oxide layer 431b and 432b disposed on the sputtered layer 431a and 432a and including a Cu oxide, a conductive polymer layer 431c and 432c disposed in a band portion B1 and B2 and including a polymer material, and a plated layer 431d and 432d disposed on the oxide layer 431b and 432b and the conductive polymer layer 431c and 432c.

The conductive polymer layer 431c and 432c may include, for example, a first layer 431c1 and 432c1 disposed on the first surface, and a second layer 431c2 and 432c2 disposed on the second surface and spaced apart from the first layer 431c1 and 432c1.

The plated layer 431d and 432d may include a Ni plated layer 431d1 and 432d1 disposed on the oxide layer 431b and 432b in the connection portion A1 and A2 and disposed on the conductive polymer layer 431c and 432c in the band portion B1 and B2, and a Sn plated layer 431d2 and 432d2 disposed on the Ni plated layer 431d1 and 432d1.

In a multilayer electronic component 400 according to an embodiment of the present disclosure, one end of the sputtered layer 431a and 432a and one end of the conductive polymer layer 431c and 432c may be disposed in a corner portion C1 and C2, respectively. In this case, the sputtered layer 431a and 432a may cover one end of the conductive polymer layer 431c and 432c in the corner portion C1 and C2. The conductive polymer layer 431c and 432c may be in contact with at least a portion of an edge EG1 and EG2 of the body 110.

The oxide layer 431b and 432b may be disposed in the connection portion A1 and A2 and the corner portion C1 and C2. The oxide layer 431b and 432b may not be disposed in the band portion B1 and B2, and thus an end portion of the oxide layer 431b and 432b may be disposed in the corner portion C1 and C2, but the present disclosure is not limited thereto.

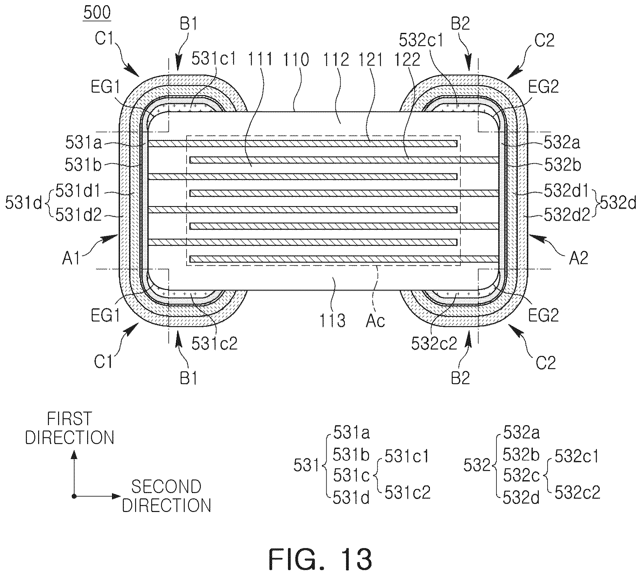

Referring to FIG. 13, a multilayer electronic component 500 according to an embodiment of the present disclosure may include a body 110 and an external electrode (531 and 532).

The external electrode 531 and 532 may include a sputtered layer 531a and 532a disposed in a connection portion A1 and A2, contacting an internal electrode 121 and 122, and including Cu, an oxide layer 531b and 532b disposed on the sputtered layer 531a and 532a and including a Cu oxide, a conductive polymer layer 531c and 532c disposed in a band portion B1 and B2 and including a polymer material, and a plated layer 531d and 532d disposed on the oxide layer 531b and 532b and the conductive polymer layer 531c and 532c.

The conductive polymer layer 531c and 532c may include, for example, a first layer 531c1 and 532c1 disposed on the first surface, and a second layer 531c2 and 532c2 disposed on the second surface and spaced apart from the first layer 531c1 and 532c1.

The plated layer 531d and 532d may include a Ni plated layer 531d1 and 532d1 disposed on the oxide layer 531b and 532b in the connection portion A1 and A2 and disposed on the conductive polymer layer 531c and 532c in the band portion B1 and B2, and a Sn plated layer 531d2 and 532d2 disposed on the Ni plated layer 531d1 and 532d1.

In a multilayer electronic component 500 according to an embodiment of the present disclosure, one end of the sputtered layer 531a and 532a may be disposed in the band portion B1 and B2. For example, one end of a first sputtered layer 531a may be disposed in a first band portion B1, and one end of a second sputtered layer 532a may be disposed in a second band portion B2. For example, the first sputtered layer 531a may be disposed on the third surface, and may extend over a portion of the first surface and a portion of the second surface, and the second sputtered layer 532a may be disposed on the fourth surface, and may extend over a portion of the first surface and a portion of the second surface.

In the band portion B1 and B2, the conductive polymer layer 531c and 532c may be disposed between the body 110 and the sputtered layer 531a and 532a. For example, in the first band portion B1, a first conductive polymer layer 531c may be disposed between the body 110 and the first sputtered layer 531a, and in the second band portion B2, a second conductive polymer layer 532c may be disposed between the body 110 and the second sputtered layer 532a. The sputtered layer 531a and 532a may be disposed to cover the conductive polymer layer 531c and 532c disposed in the band portion B1 and B2 and a corner portion C1 and C2.

The oxide layer 531b and 532b may be disposed in the connection portion A1 and A2, the band portion B1 and B2, and the corner portion C1 and C2. The oxide layer 531b and 532b may be disposed to cover the sputtered layer 531a and 532a in the connection portion A1 and A2, the band portion B1 and B2, and the corner portion C1 and C2, but the present disclosure is not limited thereto.

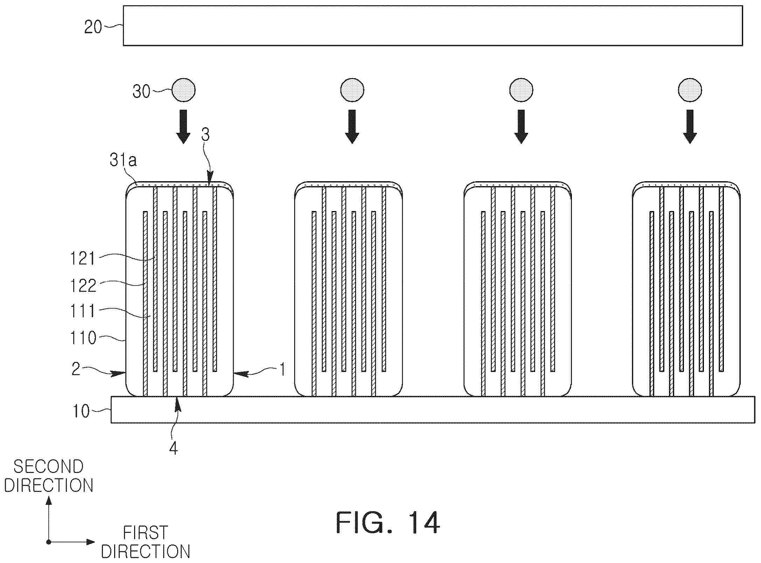

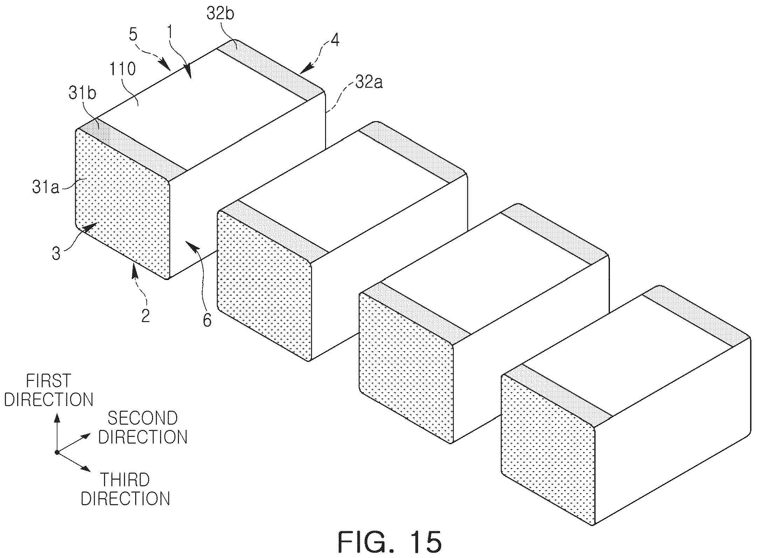

FIGS. 14 and 15 are views schematically illustrating a method for manufacturing a multilayer electronic component according to an embodiment of the present disclosure. Hereinafter, a method for manufacturing the above-described multilayer electronic component will be described with reference to FIGS. 1 to 6 and FIGS. 14 and 15. The following description may be based on a method for manufacturing of the multilayer electronic component 100 illustrated in FIGS. 1 to 6, but the following description may be equally applied to a method for manufacturing the multilayer electronic component 200, 300, 400, and 500 illustrated in FIGS. 10 to 13. Therefore, the following description of a method for manufacturing the multilayer electronic component 200, 300, 400, and 500 illustrated in FIGS. 10 to 13 will be separately mentioned only when necessary.

First, a ceramic powder may be prepared. The ceramic powder may be, for example, BaTiO₃, (Ba₁₋ₓCaₓ)TiO₃(0<x<1), Ba(Ti_{1-y}Ca_{y})O₃(0<y<1), (Ba₁₋ₓCaₓ)(Ti_{1-y}Zr_{y})O₃(0<x<1, 0<y<1), Ba(Ti_{1-y}Zr_{y})O₃(0<y<1), CaZrO₃, or (Ca₁₋ₓSrₓ)(Zr_{1-y}Ti_{y})O₃(0<x≤0.5, 0<y≤0.5). BaTiOs may be synthesized, for example, by reacting a titanium raw material such as titanium dioxide or the like with a barium raw material such as barium carbonate or the like. A method for synthesizing the ceramic powder may include, for example, a solid phase method, a sol-gel method, a hydrothermal synthesis method, or the like, but the present disclosure is not limited thereto. Next, after drying and pulverizing the prepared ceramic powder, a ceramic slurry may be prepared by mixing an organic solvent such as ethanol or the like and a binder such as polyvinyl butyral or the like, and the ceramic slurry may be applied on a carrier film, and drying the same to prepare a ceramic green sheet.

Next, a conductive paste for an internal electrode containing a metal powder, a binder, an organic solvent, or the like may be printed on the ceramic green sheet using a screen-printing method, a gravure printing method, or the like in a predetermined thickness to form an internal electrode pattern.

Thereafter, the ceramic green sheet on which the internal electrode pattern is printed may be peeled off from the carrier film, ceramic green sheets on which the internal electrode pattern is printed may be stacked and compacted by a predetermined number of layers, to form a ceramic stack body. Thereafter, the ceramic stack body may be cut into a predetermined chip size, and the cut chip may be sintered at a temperature of 1000°C or higher and 1400°C or lower. As a result, a body 110 including a dielectric layer 111 and internal electrodes 121 and 122 alternately disposed with the dielectric layer 111 and including first to sixth surfaces 1, 2, 3, 4, 5, and 6 may be formed. Thereafter, a barrel polishing process may be additionally performed to form edges EG1 and EG2 of the body 110 into a rounded shape.

Next, an electrode formation operation for forming external electrodes 131 and 132 on the body 110 may be performed. Referring to FIGS. 14 and 15, the electrode formation operation may include a first process for forming Cu films 31a and 32a on the third and fourth surfaces 3 and 4 through a sputtering method, and a second process for applying polymer compositions 31b and 32b to at least one of the first and second surfaces 1 and 2.

Specifically, referring to FIG. 14, in the first process, a plurality of bodies 110 may be aligned on a substrate 10, and then Cu particles 30 may be discharged from a target 20 in an atomic state or an ionic state to be deposited on the third surface 3 of the body 110, thereby forming the Cu film 31a. Although not illustrated, the body 110 may be turned over and the Cu particles 30 may be deposited in the same manner on the fourth surface 4 to form the Cu film 32a of FIG. 15.

Next, referring to FIG. 15, in the second process, the body 110 on which the Cu films 31a and 32a are formed may be aligned on a substrate (not illustrated), and then the polymer compositions 31b and 32b may be applied and dried on at least one of the first surface and the second surface 1 and 2. More preferably, as illustrated in FIG. 15, after the polymer compositions 31b and 32b may be applied to a portion of the first surface 1, the body 110 may be turned over and the polymer compositions 31b and 32b may be applied and dried in the same manner on the second surface 2. The application of the polymer compositions 31b and 32b may be performed, for example, through an inkjet method or the like, but the present disclosure is not limited thereto.

The polymer compositions 31b and 32b may include a polymer material. The polymer material may be, for example, an insulating material. The polymer material may be one or more of an epoxy resin, an acrylic resin, and ethyl cellulose. In this case, the polymer compositions 31b and 32b may further include a metal powder. Alternatively, the polymer material may be a conductive material including one or more of polypyrrole, polyaniline, polythiophene, and PEDOT:PSS.

The electrode formation operation illustrated in FIGS. 14 and 15 may sequentially perform the first process and the second process, but the present disclosure is not limited thereto, and may be performed in reverse order. For example, the electrode formation operation may perform the first and second processes sequentially or in reverse order. When the first and second processes are performed sequentially, the external electrodes 131 and 132 of the multilayer electronic component 100 illustrated in FIG. 2 may be formed, and when the first and second processes are performed in reverse order, the external electrodes 431 and 432 of the multilayer electronic component 400 illustrated in FIG. 12 may be formed.

In addition, by controlling amounts of the polymer compositions 31b and 32b applied in the second process such that the polymer compositions 31b and 32b flows down onto the Cu films 31a and 32a, the external electrodes 231 and 232 of the multilayer electronic component 200 illustrated in FIG. 10 may be formed.

In addition, by flipping the body 110 aligned on the substrate in the first process and depositing Cu particles on the first surface and the second surface 1 and 2, the external electrodes 331 and 332 of the multilayer electronic component 300 illustrated in FIG. 11 or the external electrodes 531 and 532 of the multilayer electronic component 500 illustrated in FIG. 13 may be formed.

Next, a heat-treatment operation of heat-treating the body 110 on which the electrode formation operation has been performed may be performed to oxidize external surfaces of the Cu films 31a and 32a. By the heat-treatment, the external surfaces of the Cu films 31a and 32a may be oxidized to form sputtered layers 131a and 132a and oxide layers 131b and 132b, and at the same time, the polymer compositions 31b and 32b may be cured to form conductive polymer layers 131c and 132c.

The heat-treatment may be performed at a temperature of, for example, 160°C to 200°C. When the above heat-treatment temperature is less than 160°C, there may be a concern that the oxide layers 131b and 132b may not be sufficiently formed, and when the above heat-treatment temperature is more than 200°C, the polymer compositions 31b and 32b may burn due to the curing temperature being exceeded.

The above heat-treatment may be performed in an atmosphere having an oxygen concentration of 30 ppm or more and 50 ppm or less in order to appropriately form the oxide layers 131b and 132b, but the present disclosure is not limited thereto.

Next, a multilayer electronic component 100 may be manufactured by forming Ni plated layers 131d1 and 132d1 and Sn plated layers 131d2 and 132d2 through a plating method. The plating method may use an electrolytic plating method and/or an electroless plating method. However, the above-described manufacturing method is illustrative, and the manufacturing method of the multilayer electronic component is not limited to the above-described manufacturing method.

The present disclosure is not limited by the above-described embodiments and accompanying drawings, but is intended to be limited by the appended claims. Therefore, various forms of substitution, modification, and change will be possible by those skilled in the art within the scope of the technical spirit of the present disclosure described in the claims, and this will also be said to fall within the scope of the present disclosure.

In addition, the expression 'an embodiment' does not indicate the same embodiment, and is provided to emphasize and describe different unique characteristics. However, an embodiment presented above is not excluded from being implemented in combination with features of another embodiment. For example, even if a matter described in one detailed embodiment is not described in another embodiment, and it can be understood as a description related to another embodiment, unless there is a description contradicting or contradicting the matter in another embodiment.

In the present disclosure, the meaning of being connected includes not only being directly connected, but also being indirectly connected through an adhesive layer or the like. In addition, the meaning of being electrically connected includes both cases of being physically connected and cases of not being connected. In addition, expressions such as first and second are used to distinguish one component from another, and do not limit the order and/or importance of the components. In some cases, without departing from the scope of rights, a first element may be named a second element, and similarly, a second element may be named a first element.

As one of various effects of the present disclosure, a multilayer electronic component having excellent reliability may be provided.

While example embodiments have been illustrated and described above, it will be apparent to those skilled in the art that modifications and variations could be made without departing from the scope of the present disclosure as defined by the appended claims.

## Claims

1. A multilayer electronic component comprising:
a body including a dielectric layer and first and second internal electrodes alternately disposed with the dielectric layer therebetween, and including a first surface and a second surface opposing each other in a first direction, a third surface and a fourth surface, connected to the first and second surfaces and opposing each other in a second direction, and a fifth surface and a sixth surface, connected to the first to fourth surfaces and opposing each other in a third direction; and
an external electrode including:
a connection portion disposed on the third surface and/or the fourth surface, and
a band portion extending from the connection portion to a portion of the first surface and a portion of the second surface,
wherein the external electrode includes:
a sputtered layer disposed in the connection portion and contacting the first and/or second internal electrode and including Cu,
an oxide layer disposed on the sputtered layer and including a Cu oxide, and
a conductive polymer layer disposed in the band portion and including a polymer material.

2. The multilayer electronic component of claim 1, wherein the conductive polymer layer includes a first layer disposed on the first surface, and a second layer spaced apart from the first layer and disposed on the second surface.

3. The multilayer electronic component of claim 1, wherein the conductive polymer layer is not disposed in the connection portion.

4. The multilayer electronic component of claim 1, wherein the external electrode includes a corner portion disposed between the connection portion and the band portion,
one end of the sputtered layer is disposed in the corner portion.

5. The multilayer electronic component of claim 4, wherein, in the corner portion, the conductive polymer layer covers the one end of the sputtered layer.

6. The multilayer electronic component of claim 4, wherein, in the corner portion, the sputtered layer covers one end of the conductive polymer layer.

7. The multilayer electronic component of claim 1, wherein one end of the conductive polymer layer is disposed in the connection portion.

8. The multilayer electronic component of claim 1, wherein one end of the sputtered layer is disposed in the band portion, and
in the band portion, the sputtered layer is disposed between the body and the conductive polymer layer.

9. The multilayer electronic component of claim 1, wherein one end of the sputtered layer is disposed in the band portion, and
in the band portion, the conductive polymer layer is disposed between the body and the sputtered layer.

10. The multilayer electronic component of claim 1, wherein an amount (at%) of Cu among a total amount (at%) of elements constituting the sputtered layer is 99 at% or more.

11. The multilayer electronic component of claim 1, wherein the external electrode further includes:
a Ni plated layer disposed on the oxide layer in the connection portion and disposed on the conductive polymer layer in the band portion, and
a Sn plated layer disposed on the Ni plated layer.

12. The multilayer electronic component of claim 1, wherein the polymer material includes an insulating resin, and
the conductive polymer layer further includes a metal particle.

13. The multilayer electronic component of claim 1, wherein the polymer material includes at least one of polypyrrole, polyaniline, polythiophene, or PEDOT:PSS.

14. A method of manufacturing a multilayer electronic component, comprising:
preparing a body including a dielectric layer and first and second internal electrodes alternately disposed with the dielectric layer therebetween, and including a first surface and a second surface opposing each other in a first direction, a third surface and a fourth surface, connected to the first and second surfaces and opposing each other in a second direction, and a fifth surface and a sixth surface, connected to the first to fourth surfaces and opposing each other in a third direction;
performing an electrode formation operation including a first operation including forming a Cu film on the third surface and the fourth surface by a sputtering method, and a second operation including applying a polymer composition to at least one surface among the first surface and the second surface, wherein the first operation and the second operation are performed sequentially or in reverse order; and
performing a heat-treatment operation including heat-treating the body on which the electrode formation operation has been performed to oxidize an external surface of the Cu film.

15. The method of claim 14, wherein the heat-treatment operation is performed at a temperature of 160°C to 200°C.
